# EUROPEAN PATENT APPLICATION

(11) **EP 4 600 677 A1**
(43) Date of publication of application: **13.08.2025**
(21) Application number: 23889166.7
(22) Date of filing: 09.11.2023
(51) Int. Cl.: G01R 31/392, G01R 31/3835, G01R 19/165, G01R 19/10, G01R 19/30, G01R 31/396

(54) **BATTERY PACK MANAGEMENT DEVICE AND OPERATION METHOD THEREOF**

(30) Priority: 11.11.2022 KR 20220151065
(71) Applicant: LG Energy Solution, Ltd., Seoul 07335 (KR)
(72) Inventor: KIM, In Sik, Daejeon 34122 (KR); YOON, Sung Yul, Daejeon 34122 (KR); LEE, Jeong Bin, Daejeon 34122 (KR); KIM, Soon Jong, Daejeon 34122 (KR); KIM, Won Kyung, Daejeon 34122 (KR); KWON, Ki Wook, Daejeon 34122 (KR); SONG, Young Seok, Daejeon 34122 (KR)
(74) Representative: Plasseraud IP
(86) International application number: PCT/KR2023/017950
(87) International publication number: WO 2024/101908

(57) **Abstract**

A battery pack management apparatus according to an embodiment disclosed herein includes a communication unit configured to receive voltages of any one battery cell group of a plurality of battery cell groups from each of a plurality of sensors configured to measure voltages of the any one battery cell group and a controller configured to calculate a median of voltages of each of the plurality of battery cell groups, calculate a voltage deviation of a plurality of battery cells of the plurality of battery cell groups with respect to a median of the voltages of each of the plurality of battery cell groups and diagnose whether any one battery cell of the plurality of battery cells is abnormal by comparing the voltage deviation of each of the plurality of battery cells with a threshold value.

## Description

### [TECHNICAL FIELD]

### CROSS-REFERENCE TO RELATED APPLICATION

This application claims priority to and the benefit of Korean Patent Application No. 10-2022-0151065 filed in the Korean Intellectual Property Office on November 11, 2022, the entire content of which is incorporated herein by reference.

### TECHNICAL FIELD

Embodiments disclosed herein relate to a battery pack management apparatus and an operating method thereof.

### [BACKGROUND ART]

An energy storage system (ESS) stores high-capacity electric energy in a plurality of battery packs including a plurality of battery cells connected in series and/or in parallel. The battery pack of the ESS may have heat generated therein by chemical reaction occurring in a process of charging and discharging electricity, and the heat may impair performance and lifetime of the battery pack. Thus, a battery pack management apparatus (or a pack battery management system (PBMS)) that monitors temperature, voltage, and current of the battery pack is driven to predict the state of the battery pack and manage the battery pack.

The battery pack is manufactured by combining a plurality of battery cells having the same design so as to ensure mass productivity during a production process. In case of a voltage abnormality behavior of a specific individual cell, chain ignition may occur inside the battery pack, such that the battery pack management apparatus has to diagnose the battery cell having the voltage abnormality behavior occurred. However, according to a conventional method of detecting the voltage abnormality behavior of the battery cell by the battery pack management apparatus, a reduction rate of a voltage of an average battery cell with respect to a voltage of a single battery cell is calculated or a rapid change of a temperature is measured, but voltage fluctuation caused by noise inside the battery pack and instantaneous voltage change of a battery cell may not be detected, making it difficult to detect the voltage abnormality behavior of the battery cell.

### [DISCLOSURE]

### [TECHNICAL PROBLEM]

Embodiments disclosed herein aim to provide a battery pack management apparatus and an operating method thereof in which an instantaneous voltage change of a battery cell may be detected based on a median value of voltages of a battery cell group, thereby early diagnosing an abnormal battery cell.

Technical problems of the embodiments disclosed herein are not limited to the above-described technical problems, and other unmentioned technical problems would be clearly understood by one of ordinary skill in the art from the following description.

### [TECHNICAL SOLUTION]

A battery pack management apparatus according to an embodiment disclosed herein includes a communication unit configured to receive voltages of any one battery cell group of a plurality of battery cell groups from each of a plurality of sensors configured to measure voltages of the any one battery cell group and a controller configured to calculate a median of voltages of each of the plurality of battery cell groups, calculate a voltage deviation of a plurality of battery cells of the plurality of battery cell groups with respect to a median of the voltages of each of the plurality of battery cell groups and diagnose whether any one battery cell of the plurality of battery cells is abnormal by comparing the voltage deviation of each of the plurality of battery cells with a threshold value.

According to an embodiment, the communication unit may be further configured to receive the voltages of the any one battery cell group, measured by each of the plurality of sensors, among the plurality of battery cell groups, from each of the plurality of sensors, and the controller may be further configured to calculate the median of the voltages of the plurality of battery cell groups and determine whether the median of the voltages of the plurality of battery cell groups falls within a threshold range.

According to an embodiment, the controller may be further configured to calculate the median of the voltages of each of the plurality of battery cell groups, when the median of the voltages of the plurality of battery cell groups falls within the threshold range.

According to an embodiment, the controller may be further configured to calculate the voltage deviation of the plurality of battery cells of each of the plurality of battery cell groups with respect to the median of the voltages of each of the plurality of battery cell groups and obtain a maximum value among positive deviations and a maximum value among negative deviations from the voltage deviation of each of the plurality of battery cells of the plurality of battery cell groups.

According to an embodiment, the controller may be further configured to determine whether the maximum value among the positive deviations of each of the plurality of battery cells exceeds an upper threshold value and whether the maximum value among the negative deviations of each of the plurality of battery cells is less than a lower threshold value.

According to an embodiment, the controller may be further configured to, when the maximum value among the positive deviations of the any one battery cell of the plurality of battery cells exceeds the upper threshold value and the maximum value among the negative deviations of the battery cell is less than the lower threshold value, diagnose the battery cell as an abnormal battery cell.

An operating method of a battery pack management apparatus according to an embodiment disclosed herein includes receiving voltages of any one battery cell group of a plurality of battery cell groups from each of a plurality of sensors, calculating a median of voltages of each of the plurality of battery cell groups, calculating a voltage deviation of a plurality of battery cells with respect to a median of the voltages of each of the plurality of battery cell groups, and diagnosing whether any one battery cell of the plurality of battery cells is abnormal by comparing the voltage deviation of each of the plurality of battery cells with a threshold value.

According to an embodiment, the receiving of the voltages of the any one battery cell group of the plurality of battery cell groups from each of the plurality of sensors may include receiving the voltages of the any one battery cell group, measured by each of the plurality of sensors, among the plurality of battery cell groups, from each of the plurality of sensors and calculating the median of the voltages of the plurality of battery cell groups and determine whether the median of the voltages of the plurality of battery cell groups falls within a threshold range.

According to an embodiment, the calculating of the median of the voltages of each of the plurality of battery cell groups may include, when the median of the voltages of the plurality of battery cell groups is within the threshold range, calculating the median of the voltages of each of the plurality of battery cell groups.

According to an embodiment, the calculating of the voltage deviation of the plurality of battery cells with respect to the median of the voltages of each of the plurality of battery cell groups may include obtaining a maximum value among positive deviations and a maximum value among negative deviations from the voltage deviation of each of the plurality of battery cells of the plurality of battery cell groups.

According to an embodiment, the diagnosing of whether the any one battery cell of the plurality of battery cells is abnormal by comparing the voltage deviation of each of the plurality of battery cells with a threshold value may include determining whether the maximum value among the positive deviations of each of the plurality of battery cells exceeds an upper threshold value and whether the maximum value among the negative deviations of each of the plurality of battery cells is less than a lower threshold value.

According to an embodiment, the diagnosing of whether the any one battery cell of the plurality of battery cells is abnormal by comparing the voltage deviation of each of the plurality of battery cells with a threshold value may include, when the maximum value among the positive deviations of the any one battery cell of the plurality of battery cells exceeds the upper threshold value and the maximum value among the negative deviations of the battery cell is less than the lower threshold value, diagnosing the battery cell as an abnormal battery cell.

### [ADVANTAGEOUS EFFECTS]

With the battery pack management apparatus and the operating method thereof according to an embodiment disclosed herein, instantaneous voltage change of a battery cell may be detected based on a median value of voltages of a battery cell group, thereby early diagnosing an abnormal battery cell.

### [DESCRIPTION OF DRAWINGS]

FIG. 1 illustrates a battery pack according to an embodiment disclosed herein.
FIG. 2 is a block diagram illustrating a configuration of a battery pack management apparatus, according to an embodiment disclosed herein.
FIG. 3 is a graph showing change of a median value of voltages of a battery cell group over time according to an embodiment disclosed herein.
FIG. 4 is a flowchart of a method of analyzing a voltage deviation of a battery cell of a controller, according to an embodiment disclosed herein.
FIG. 5 is a flowchart of an operating method of a battery pack management apparatus according to an embodiment disclosed herein.
FIG. 6 is a block diagram showing a hardware configuration of a computing system to implement a battery pack management apparatus according to an embodiment disclosed herein.

### [MODE FOR INVENTION]

Hereinafter, some embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present document.

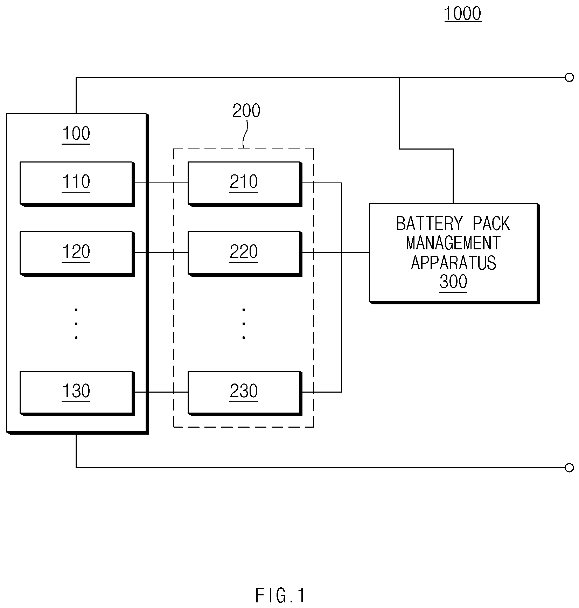

FIG. 1 illustrates a battery pack according to an embodiment disclosed herein.

Referring to FIG. 1, a battery pack 1000 according to an embodiment disclosed herein may include a plurality of battery cells 100, a charging/discharging device (not shown), a plurality of sensors 200, and a battery pack management apparatus 300.

The battery pack 1000 may supply power to a target device (not shown). To this end, the battery pack 1000 may be electrically connected to the target device. Herein, the target device may include an electrical, electronic, or mechanical device that operates by receiving power from the battery pack 1000, and for example, the target device may be, but not limited to, an energy storage system (ESS) or an electric vehicle (EV).

According to an embodiment, the plurality of battery cells 100 may include a plurality of battery cell groups 110, 120, and 130. Although three battery cell groups are illustrated in FIG. 1, the present disclosure is not limited thereto, and the plurality of battery cells 100 may include n battery cell groups (n is a natural number of 2 or greater).

For example, when the plurality of battery cells 100 include 42 battery cells, the plurality of battery cells 100 may include three battery cell groups 110, 120, and 130, each of which may include 14 battery cells.

For example, when the plurality of battery cells 100 include 28 battery cells, the plurality of battery cells 100 may include two battery cell groups 110 and 120, each of which may include 14 battery cells.

The plurality of battery cell groups 110, 120, and 130 may include a plurality of battery cells. The battery cell, which is a basic unit of a battery available by charging and discharging electrical energy, may be a lithium ion (Li-ion) battery, an Li-ion polymer battery, a nickel-cadmium (Ni-Cd) battery, a nickel hydrogen (Ni-MH) battery, etc., and is not limited thereto.

The battery cell may be manufactured through a series of manufacturing processes including an electrode manufacturing process, an assembly process, a chemical conversion process, etc., and manufactured battery cells may be connected in series or in parallel to each other and embedded in a case structure to implement the battery cell groups 110, 120, and 130. The completed battery cell groups 110, 120, and 130 may be connected in series or in parallel to each other and embedded in a case structure to implement the battery pack 1000.

According to an embodiment, the plurality of battery cell groups 110, 120, and 130 may include a plurality of battery cells connected in series and/or in parallel. According to an embodiment, the number of battery cells included in each of the plurality of battery cell groups 110, 120, and 130 may be the same.

According to an embodiment, each of the plurality of sensors 210, 220, and 230 may be implemented in the form of a battery monitoring integrated circuit (BMIC) that monitors voltages, currents, temperatures, etc., of the plurality of battery cells. Hereinbelow, a description will be made of an example where each of the plurality of sensors 210, 220, and 230 is implemented with a BMIC.

Each of the plurality of sensors 210, 220, and 230 may measure a voltage of any one battery cell group among the plurality of battery cell groups 110, 120, and 130. More specifically, the plurality of sensors 210, 220, and 230 may respectively match the plurality of battery cell groups 110, 120, and 130 on a one-to-one basis. Although the plurality of functional modules are illustrated as three in FIG. 1, the present disclosure is not limited thereto, and the plurality of sensors 210, 220, and 230 may include n sensors (n is a natural number of 2 or greater).

For example, when the plurality of battery cells 100 include three battery cell groups 110, 120, and 130, the plurality of sensors 200 may include three sensors 210, 220, and 230. The plurality of sensors 210, 220, and 230 may respectively one-to-one match the plurality of battery cell groups 110, 120, and 130 to measure a voltage of a matched battery cell group among the battery cell groups 110, 120, and 130. For example, the first sensor 210 may measure a voltage of the first battery cell group 110, the second sensor 220 may measure a voltage of the second battery cell group 120, and the third sensor 230 may measure a voltage of the third battery cell group 130.

For example, when the plurality of battery cells 100 include two battery cell groups 110 and 120, the plurality of sensors 200 may include two sensors 210 and 220. The plurality of sensors 210 and 220 may respectively one-to-one match the plurality of battery cell groups 110 and 120 to measure a voltage of a matched battery cell group between the battery cell groups 110 and 120.

Each of the plurality of sensors 210, 220, and 230 may be electrically connected to a positive electrode and a negative electrode of each of the plurality of battery cells to repeatedly measure a voltage of each of the plurality of battery cells. Each of the plurality of sensors 210, 220, and 230 may repeatedly measure a voltage of each of the plurality of battery cell groups 110, 120, and 130 at specific intervals to generate voltage change data of each of the plurality of battery cell groups 110, 120, and 130.

Each of the plurality of sensors 210, 220, and 230 may transmit information about the measured voltage, current, temperature, etc., of any one battery cell group among the plurality of battery cell groups 110, 120, and 130, to the battery pack management apparatus 300.

The plurality of sensors 210, 220, and 230 may manage and/or control a state and/or an operation of the plurality of battery cell groups 110, 120, and 130. For example, the plurality of sensors 210, 220, and 230 may manage and/or control a state and/or an operation of the plurality of battery cells included in the plurality of battery cell groups 110, 120, and 130. The plurality of sensors 210, 220, and 230 may manage charging and/or discharging of the plurality of battery cell groups 110, 120, and 130.

The plurality of sensors 210, 220, and 230 may monitor voltages, currents, temperatures, etc., of the plurality of battery cell groups 110, 120, and 130 and/or the plurality of battery cells included in the plurality of battery cell groups 110, 120, and 130. A sensor or various measurement modules for monitoring performed by the plurality of sensors 210, 220, and 230, which are not shown, may be additionally installed in a charging/discharging path or any position of the plurality of battery cell groups 110, 120, and 130.

The plurality of sensors 210, 220, and 230 may be configured to communicate with the battery pack management apparatus 300. The plurality of sensors 210, 220, and 230 may receive a control signal, such as a command, etc., for controlling the battery cell groups 110, 120, and 130 from the battery pack management apparatus 300. The plurality of sensors 210, 220, and 230 may transmit a measurement value by the monitoring, a parameter calculated from the same, etc., to the battery pack management apparatus 300.

The battery pack management apparatus (PBMS) 300 may control an overall operation of the battery pack 1000 and manage a state of the battery pack 1000.

More specifically, the battery pack management apparatus 300 may be configured to communicate with the plurality of sensors 210, 220, and 230. The battery pack management apparatus 300 may receive various data related to the plurality of battery cell groups 110, 120, and 130 from the plurality of sensors 210, 220, and 230. The battery pack management apparatus 300 may monitor the plurality of battery cell groups 110, 120, and 130 and/or the plurality of battery cells included in the plurality of battery cell groups 110, 120, and 130, based on measurement values of voltages, currents, temperatures, etc., of the plurality of battery cell groups 110, 120, and 130, received from the plurality of sensors 210, 220, and 230.

The battery pack management apparatus 300 may calculate a parameter indicating monitored states of the plurality of battery cell groups 110, 120, and 130 and/or the plurality of battery cells included in the plurality of battery cell groups 110, 120, and 130, e.g., a state of charge (SOC), a state of health (SOH) etc.

The battery pack 1000 may diagnose whether any one of the plurality of battery cells is abnormal, based on the measurement values such as voltages, currents, temperatures, etc., of the plurality of battery cell groups 110, 120, and 130, received from the plurality of sensors 210, 220, and 230, and the directly calculated parameter indicating the states of the plurality of battery cell groups 110, 120, and 130 and/or the plurality of battery cells included in the plurality of battery cell groups 110, 120, and 130, etc., the SOC, the SOH, etc.

The battery pack management apparatus 300 may transmit various control signals for controlling the plurality of battery cell groups 110, 120, and 130 to the plurality of sensors 210, 220, and 230. That is, the battery pack management apparatus 300 may function as a higher-level controller for the plurality of sensors 210, 220, and 230. The battery pack management apparatus 300 may function as a master controller in performing communication with the plurality of sensors 210, 220, and 230 in a system.

The battery pack management apparatus 300 may control an operation of the charging/discharging device. For example, the battery pack management apparatus 300 may monitor a voltage of the battery pack 1000 and monitor a failure of the charging/discharging device, etc.

The battery pack management apparatus 300 may control an operation of a relay (not shown). For example, the battery pack management apparatus 300 may short-circuit the relay 300 to supply power to the target device. The sensor may short-circuit the relay when a charging device is connected to the battery pack 1000.

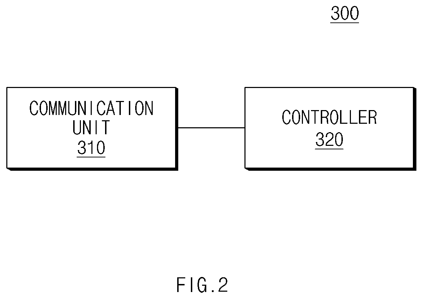

FIG. 2 is a block diagram illustrating a configuration of a battery pack management apparatus, according to an embodiment disclosed herein.

Hereinbelow, a configuration of the battery pack management apparatus 300 will be described in detail with reference to FIG. 2. Referring to FIG. 2, the battery pack management apparatus 300 may include a communication unit 310 and a controller 320.

The communication unit 310 may receive voltages of the plurality of battery cell groups 110, 120, and 130 from the plurality of battery sensors 110, 120, and 130. More specifically, the communication unit 310 may receive a voltage of any one battery cell group, measured by each of the plurality of sensors 210, 220, and 230, among the plurality of battery cell groups 110, 120, and 130, from each of the plurality of sensors 210, 220, and 230.

The communication unit 310 may be connected to the plurality of sensors 210, 220, and 230 through a wired/wireless network. For example, the communication unit 310 may be connected to each of the plurality of sensors 210, 220, and 230 through Bluetooth, WiFi, ZigBee, controller area network (CAN) communication, or Ethernet communication.

The controller 320 may calculate a median of the voltages of the plurality of battery cell groups 110, 120, and 130. That is, the controller 320 may calculate a median of the voltages of all of the plurality of battery cells 100. The controller 320 may determine whether the median of the voltages of the plurality of battery cell groups 110, 120, and 130 falls within a threshold range. For example, the controller 320 may determine whether the median of the voltages of the plurality of battery cell groups 110, 120, and 130 falls within a threshold range above 3.4 V and below 4.2 V.

The controller 320 may calculate a median of voltages of each of the plurality of battery cell groups 110, 120, and 130 when the median of the voltages of the plurality of battery cell groups 110, 120, and 130 is within the threshold range.

For example, when 42 battery cells form a total of three battery cell groups 110, 120, and 130, each of which includes 14 battery cells, the first battery cell group 110 may measure voltages of 1^{st} to 14^{th} battery cells, the second battery cell group 120 may measure voltages of 15^{th} to 28^{th} battery cells, and the third battery cell group 130 may measure voltages of 29^{th} to 42^{nd} battery cells.

Herein, the controller 320 may calculate a median of the voltages of the 1^{st} to 14^{th} battery cells included in the first battery cell group 110, calculate a median of the voltages of the 15^{th} to 28^{th} battery cells included in the second battery cell group 120, and calculate a median of the voltages of the 15^{th} to 28^{th} battery cells included in the third battery cell group 130. That is, the controller 320 may calculate the median of the voltages, measured in real time, of each of the plurality of battery cell groups 110, 120, and 130.

The controller 320 may calculate a median of voltages of each of the plurality of battery cell groups 110, 120, and 130 when the median of the voltages of the plurality of battery cell groups 110, 120, and 130 is within the threshold range.

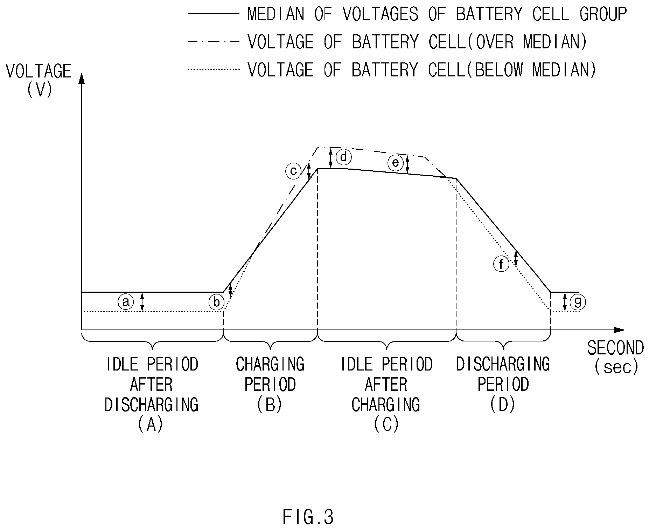

FIG. 3 is a graph showing change of a median value of voltages of a battery cell group over time according to an embodiment disclosed herein.

Referring to FIG. 3, the controller 320 may calculate a change of the median of the voltages of each of the plurality of battery cell groups 110, 120, and 130 over time. For example, the controller 320 may calculate a change of the median of the voltages of each of the plurality of battery cell groups 110, 120, and 130 during an idle period A after discharging, a charging period B, an idle period C after charging, and a discharging period D of the battery pack 1000.

The controller 320 may calculate a voltage deviation of a plurality of battery cells included in each of the plurality of battery cell groups 110, 120, and 130 with respect to the median of the voltages of each of the plurality of battery cell groups 110, 120, and 130.

More specifically, the controller 320 may calculate a voltage deviation of each battery cell included in each battery cell group with respect to the median of the voltages of each of the plurality of battery cell groups 110, 120, and 130.

For example, the controller 320 may calculate a first median that is a median of voltages of the first battery cell group 110 over time, calculate a second median that is a median of voltages of the second battery cell group 120 over time, and calculate a third median that is a median of voltages of the third battery cell group 130 over time.

For example, the controller 320 may calculate a deviation of the voltages of the 1^{st} to 14^{th} battery cells included in the first battery cell group 110 with respect to the first median, calculate a deviation of the voltages of the 15^{th} to 28^{th} battery cells included in the second battery cell group 120 with respect to the second median, and calculate a deviation of the voltages of the 29^{th} to 42^{th} battery cells included in the third battery cell group 130 with respect to the third median.

For example, the controller 320 may compare the voltage of the 1^{st} battery cell with the median of the voltages of the first battery cell group 110 to calculate the voltage deviation of the 1^{st} battery cell. For example, the controller 320 may calculate the deviation of the voltage of the 1^{st} battery cell with respect to the first median of the first battery cell group 110 during the idle period A after discharging, the charging period B, the idle period C after charging, and the discharging period D of the battery pack 1000.

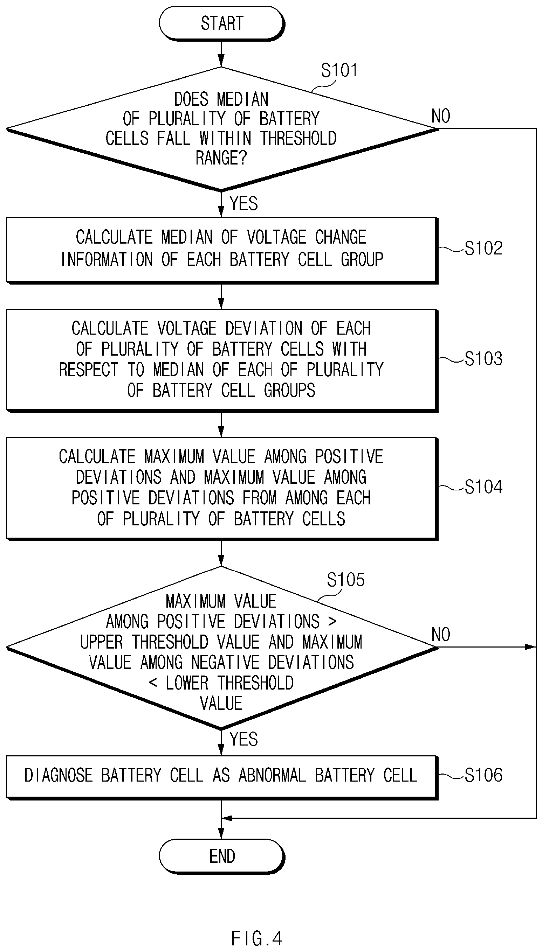

FIG. 4 is a flowchart of a method of analyzing a voltage deviation of a battery cell of a controller, according to an embodiment disclosed herein.

Hereinbelow, referring to FIG. 4, a method, performed by the controller 320, of diagnosing a battery cell based on a voltage deviation of each of a plurality of battery cells will be described in detail.

In operation S101, the controller 320 may calculate the median of the voltages of all of the plurality of battery cells 100. In operation S101, the controller 320 may determine whether the median of the voltages of the plurality of battery cell groups 110, 120, and 130 falls within a threshold range.

In operation S102, the controller 320 may calculate the median of the voltages of each of the plurality of battery cell groups 110, 120, and 130 when the median of the voltages of the plurality of battery cell groups 110, 120, and 130 is within the threshold range.

In operation S103, the controller 320 may calculate the voltage deviation of the plurality of battery cells included in each of the plurality of battery cell groups 110, 120, and 130 with respect to the median of the voltages of each of the plurality of battery cell groups 110, 120, and 130.

In operation S104, the controller 320 may obtain a maximum value among positive (+) deviations and a maximum value among negative (-) deviations from among voltage deviations of each of the plurality of battery cells of each of the plurality of battery cell groups 110, 120, and 130. Herein, the positive deviation may be calculated when a voltage of a battery cell exceeds or is over a median of voltages of a battery cell group. The negative deviation may be calculated when a voltage of a battery cell is less than or below a median of voltages of a battery cell group.

In operation S104, for example, the controller 320 may identify the voltage deviation of the 1^{st} battery cell with respect to the first median of the first battery cell group 110 as a positive deviation or a negative deviation. Herein, the positive deviation may be calculated when the voltage of the first battery cell exceeds the first median of the first battery cell group 110. The negative deviation may be calculated when the voltage of the first battery cell is less than the first median of the first battery cell group 110.

In operation S104, referring back to FIG. 3, for example, the controller 320 may calculate, as negative deviations of the battery cell, 'a deviation ⓐ of the idle period A after discharging', 'a deviation ⓑ of the charging period B', 'a deviation ⓕ of the discharging period D', and 'a deviation ⓖ of the discharging period D' of the battery pack 1000. In operation S104, for example, the controller 320 may calculate, as positive deviations of the battery cell, 'a deviation ⓒ of the charging period B', 'a deviation ⓓ of the idle period C after charging', and 'a deviation ⓔ of the idle period C after charging'.

In operation S104, the controller 320 may obtain a maximum value among positive deviations and a maximum value among negative deviations from among voltage deviations of each of the plurality of battery cells. In operation S104, for example, the controller 320 may calculate, as the maximum value among the positive deviations, the greatest value among 'the deviation ⓒ of the charging period B', 'the deviation ⓓ of the idle period C after charging', and 'the deviation ⓔ of the idle period C after charging', calculated as the positive deviations of the battery cell. In operation S104, for example, the controller 320 may calculate 'the deviation ⓓ of the idle period C after charging', as the maximum value among the positive deviations of the battery cell.

In operation S104, for example, the controller 320 may calculate, as the maximum value among the negative deviations, a value having the greatest absolute value among 'the deviation ⓐ of the idle period A', 'the deviation ⓑ of the charging period B', 'the deviation ⓕ of the discharging period D', and 'the deviation ⓖ of the discharging period D', calculated as the negative deviations of the battery cell. For example, the controller 320 may calculate 'the deviation ⓐ of the idle period A', as the maximum value among the negative deviations of the battery cell.

In operation S105, the controller 320 may compare the voltage deviation of each of the plurality of battery cells 100 with a threshold value to diagnose whether any one of the plurality of battery cells 100 is abnormal.

In operation S105, more specifically, the controller 320 may determine whether the maximum value among the positive deviations of each of the plurality of battery cells 100 exceeds an upper threshold value. In operation S105, the controller 320 may determine whether the maximum value among the negative deviations of each of the plurality of battery cells 100 is less than a lower threshold value. Herein, the upper threshold value and the lower threshold value may be set based on the SOH of the plurality of battery cells 100, previously calculated by the controller 320.

In operation S105, for example, the controller 320 may determine whether 'the deviation ⓓ of the idle period C after charging', which is the maximum value among the positive deviations of the battery cell, exceeds the upper threshold value. In operation S105, the controller 320 may determine whether 'the deviation ⓐ of the idle period A', which is the maximum value among the negative deviations of the battery cell, is less than the lower threshold value.

In operation S106, the controller 320 may determine that the battery cell is abnormal, when the maximum value among the positive deviations of any one of the plurality of battery cells 100 exceeds the upper threshold value and the maximum value among the negative deviations of the battery cell is less than the lower threshold value.

As described above, the battery pack management apparatus according to an embodiment disclosed herein may detect an instantaneous voltage change of a battery cell based on a median of voltages of a battery cell group, thereby early diagnosing an abnormal battery cell.

Moreover, the battery pack management apparatus 300 may calculate a voltage change for each battery cell group to diagnose states of a plurality of battery cell groups.

In addition, the battery pack management apparatus 300 may calculate a voltage deviation of a battery cell based on the median of the voltages of the battery cell group, thereby preventing the battery cell from being misdiagnosed due to the voltage deviation of the battery cell, occurring as a normal battery cell is deteriorated.

The battery pack management apparatus 300 may compare a voltage change of each of the plurality of battery cells with a voltage change of the plurality of battery cell groups to diagnose abnormality of any one of the plurality of battery cells.

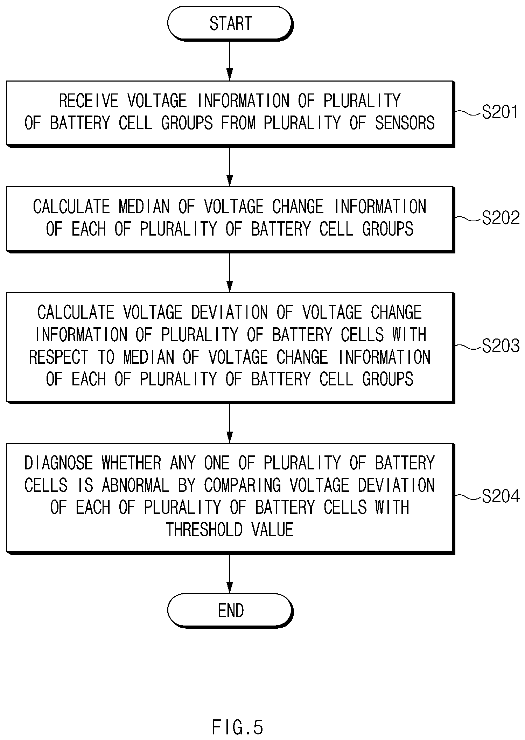

FIG. 5 is a flowchart of an operating method of a battery pack management apparatus according to an embodiment disclosed herein.

The battery pack management apparatus 300 may be substantially the same as the battery pack management apparatus 300 described with reference to FIGS. 1 to 4, and thus will be briefly described to avoid redundant description.

Referring to FIG. 5, an operating method of the battery pack management apparatus may include operation S201 of receiving the voltages of the plurality of battery cell groups 110, 120, and 130 from the plurality of sensors 210, 220, and 230, operation S202 of calculating a median of voltages of each of the plurality of battery cell groups 110, 120, and 130, operation S203 of calculating voltage deviations of the plurality of battery cells of each of the plurality of battery cell groups 110, 120, and 130 with respect to the median of the voltages of each of the plurality of battery cell groups 110, 120, and 130, and operation S204 of diagnosing whether any one of the plurality of battery cells is abnormal by comparing the voltage deviation of each of the plurality of battery cells with a threshold value.

Hereinbelow, operations S201 through S204 will be described in detail.

In operation S201, the communication unit 310 may receive the voltages of the plurality of battery cell groups 110, 120, and 130 from the plurality of battery sensors 210, 220, and 230.

In operation S201, more specifically, the communication unit 310 may receive the voltage of any one battery cell group, measured by each of the plurality of sensors 210, 220, and 230, among the plurality of battery cell groups 110, 120, and 130, from each of the plurality of sensors 210, 220, and 230.

In operation S201, the controller 320 may calculate the median of the voltages of the plurality of battery cell groups 110, 120, and 130. That is, the controller 320 may calculate the median of the voltages of all of the plurality of battery cells 100.

In operation S201, the controller 320 may determine whether the median of the voltages of the plurality of battery cell groups 110, 120, and 130 falls within a threshold range.

In operation S201, the controller 320 may calculate the median of the voltages of each of the plurality of battery cell groups 110, 120, and 130 when the median of the voltages of the plurality of battery cell groups 110, 120, and 130 is within the threshold range. In operation S201, that is, the controller 320 may calculate the median of the voltages, measured in real time, of each of the plurality of battery cell groups 110, 120, and 130.

In operation S202, the controller 320 may calculate the median of the voltages of each of the plurality of battery cell groups 110, 120, and 130 when the median of the voltages of the plurality of battery cell groups 110, 120, and 130 is within the threshold range.

In operation S203, the controller 320 may calculate the voltage deviation of the plurality of battery cells included in each of the plurality of battery cell groups 110, 120, and 130 with respect to the median of the voltages of each of the plurality of battery cell groups 110, 120, and 130.

In operation S203, more specifically, the controller 320 may calculate the voltage deviation of each battery cell included in each battery cell group with respect to the median of the voltages of each of the plurality of battery cell groups 110, 120, and 130.

In operation S203, for example, the controller 320 may calculate the first median that is a median of voltages of the first battery cell group 110 over time, calculate the second median that is a median of voltages of the second battery cell group 120 over time, and calculate the third median that is a median of voltages of the third battery cell group 130 over time.

In operation S203, the controller 320 may calculate the deviation of the voltages of the 1^{st} to 14^{th} battery cells included in the first battery cell group 110 with respect to the first median, calculate the deviation of the voltages of the 15^{th} to 28^{th} battery cells included in the second battery cell group 120 with respect to the second median, and calculate the deviation of the voltages of the 29^{th} to 42^{th} battery cells included in the third battery cell group 130 with respect to the third median.

In operation S203, the controller 320 may obtain the maximum value among the positive (+) deviations and the maximum value among the negative (-) deviations from among the voltage deviations of each of the plurality of battery cells of each of the plurality of battery cell groups 110, 120, and 130. Herein, the positive deviation may be calculated when a voltage of a battery cell exceeds a median of voltages of a battery cell group. The negative deviation may be calculated when a voltage of a battery cell is less than a median of voltages of a battery cell group.

In operation S203, for example, the controller 320 may identify the voltage deviation of the 1^{st} battery cell with respect to the first median of the first battery cell group 110 as a positive deviation or a negative deviation. Herein, the positive deviation may be calculated when the voltage of the first battery cell exceeds the first median of the first battery cell group 110. The negative deviation may be calculated when the voltage of the first battery cell is less than the first median of the first battery cell group 110.

In operation S204, the controller 320 may compare the voltage deviation of each of the plurality of battery cells 100 with a threshold value to diagnose whether any one of the plurality of battery cells 100 is abnormal.

In operation S204, more specifically, the controller 320 may determine whether the maximum value among the positive deviations of each of the plurality of battery cells 100 exceeds an upper threshold value. In operation S204, the controller 320 may determine whether the maximum value among the negative deviations of each of the plurality of battery cells 100 is less than a lower threshold value. Herein, the upper threshold value and the lower threshold value may be set based on the SOH of the plurality of battery cells 100, previously calculated by the controller 320.

In operation S204, the controller 320 may determine that the battery cell is abnormal, when the maximum value among the positive deviations of any one of the plurality of battery cells 100 exceeds the upper threshold value and the maximum value among the negative deviations of the battery cell is less than the lower threshold value.

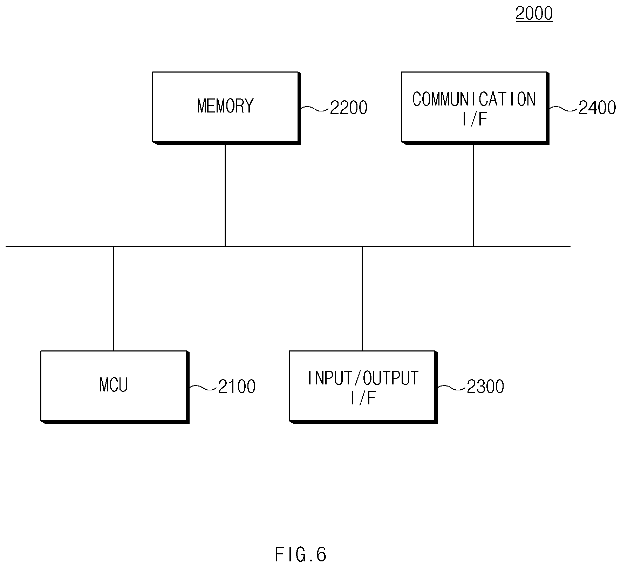

FIG. 6 is a block diagram showing a hardware configuration of a computing system to implement a battery pack management apparatus according to an embodiment disclosed herein.

Referring to FIG. 6, a computing system 2000 according to an embodiment disclosed herein may include an MCU 21000, a memory 2200, an input/output I/F 2300, and a communication I/F 2400.

The MCU 21000 may be a processor that executes various programs (e.g., a battery pack management apparatus operating program, etc.) stored in the memory 2200, processes various data through these programs, and perform the above-described functions of the battery pack management apparatus 300 shown in FIG. 1.

The memory 2200 may store various programs regarding operations of the battery pack management apparatus 300. Moreover, the memory 2200 may store operation data of the battery pack management apparatus 300.

The memory 2200 may be provided in plural, depending on a need. The memory 2200 may be volatile memory or non-volatile memory. For the memory 2200 as the volatile memory, random access memory (RAM), dynamic RAM (DRAM), static RAM (SRAM), etc., may be used. For the memory 2200 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 2200 are merely examples and are not limited thereto.

The input/output I/F 2300 may provide an interface for transmitting and receiving data by connecting an input device (not shown) such as a keyboard, a mouse, a touch panel, etc., and an output device such as a display (not shown), etc., to the MCU 21000.

The communication I/F 2400, which is a component capable of transmitting and receiving various data to and from a server, may be various devices capable of supporting wired or wireless communication. For example, a program for resistance measurement and abnormality diagnosis of the battery cell or various data may be transmitted and received to and from a separately provided external server through the communication I/F 2400.

The above description is merely illustrative of the technical idea of the present disclosure, and various modifications and variations will be possible without departing from the essential characteristics of the present disclosure by those of ordinary skill in the art to which the present disclosure pertains.

Therefore, the embodiments disclosed in the present disclosure are intended for description rather than limitation of the technical spirit of the present disclosure and the scope of the technical spirit of the present disclosure is not limited by these embodiments. The protection scope of the present disclosure should be interpreted by the following claims, and all technical spirits within the same range should be understood to be included in the range of the present disclosure.

### [Explanation of Reference Numerals or Symbols]

1000: Battery Pack
100: Plurality of Battery Cells
110: First Battery Cell Group
120: Second Battery Cell Group
130: Third Battery Cell Group
120: Sensor
210: First Sensor
220: Second Sensor
230: Third Sensor
300: Battery Pack Management Apparatus
310: Communication Unit
320: Controller
2000: Computing System
21000: MCU
2200: Memory
2300: Input/Output I/F
2400: Communication I/F

## Claims

1. A battery pack management apparatus comprising:
a communication unit configured to receive voltages of any one battery cell gro up of a plurality of battery cell groups from each of a plurality of sensors configured to measure voltages of the any one battery cell group; and
a controller configured to:
calculate a median of voltages of each of the plurality of battery cell groups;
calculate a voltage deviation of a plurality of battery cells of the plurality of batt ery cell groups with respect to a median of the voltages of each of the plurality of battery cell groups; and
diagnose whether any one battery cell of the plurality of battery cells is abnorma l by comparing the voltage deviation of each of the plurality of battery cells with a thres hold value.

2. The battery pack management apparatus of claim 1, wherein the communication unit is further configured to receive the voltages of the any one battery cell group, measu red by each of the plurality of sensors, among the plurality of battery cell groups, from e ach of the plurality of sensors, and
the controller is further configured to calculate the median of the voltages of the plurality of battery cell groups and determine whether the median of the voltages of the p lurality of battery cell groups falls within a threshold range.

3. The battery pack management apparatus of claim 2, wherein the controller is fur ther configured to calculate the median of the voltages of each of the plurality of battery cell groups, when the median of the voltages of the plurality of battery cell groups falls within the threshold range.

4. The battery pack management apparatus of claim 3, wherein the controller is fur ther configured to:
calculate the voltage deviation of the plurality of battery cells of each of the plur ality of battery cell groups with respect to the median of the voltages of each of the plura lity of battery cell groups; and
obtain a maximum value among positive deviations and a maximum value amon g negative deviations from the voltage deviation of each of the plurality of battery cells o f the plurality of battery cell groups.

5. The battery pack management apparatus of claim 4, wherein the controller is fur ther configured to determine whether the maximum value among the positive deviations of each of the plurality of battery cells exceeds an upper threshold value and whether the maximum value among the negative deviations of each of the plurality of battery cells is less than a lower threshold value.

6. The battery pack management apparatus of claim 5, wherein the controller is fur ther configured to, when the maximum value among the positive deviations of the any o ne battery cell of the plurality of battery cells exceeds the upper threshold value and the maximum value among the negative deviations of the battery cell is less than the lower t hreshold value, diagnose the battery cell as an abnormal battery cell.

7. An operating method of a battery pack management apparatus, the operating method comprising:
receiving voltages of any one battery cell group of a plurality of battery cell gro ups from each of a plurality of sensors;
calculating a median of voltages of each of the plurality of battery cell groups; calculating a voltage deviation of a plurality of battery cells with respect to a median of t he voltages of each of the plurality of battery cell groups; and
diagnosing whether any one battery cell of the plurality of battery cells is abnor mal by comparing the voltage deviation of each of the plurality of battery cells with a thr eshold value.

8. The operating method of claim 7, wherein the receiving of the voltages of the an y one battery cell group of the plurality of battery cell groups from each of the plurality o f sensors comprises:
receiving the voltages of the any one battery cell group, measured by each of the plurality of sensors, among the plurality of battery cell groups, from each of the plurality of sensors; and
calculating the median of the voltages of the plurality of battery cell groups and determine whether the median of the voltages of the plurality of battery cell groups falls within a threshold range.

9. The operating method of claim 8, wherein the calculating of the median of the v oltages of each of the plurality of battery cell groups comprises, when the median of the voltages of the plurality of battery cell groups is within the threshold range, calculating t he median of the voltages of each of the plurality of battery cell groups.

10. The operating method of claim 9, wherein the calculating of the voltage deviatio n of the plurality of battery cells with respect to the median of the voltages of each of the plurality of battery cell groups comprises obtaining a maximum value among positive de viations and a maximum value among negative deviations from the voltage deviation of each of the plurality of battery cells of the plurality of battery cell groups.

11. The operating method of claim 10, wherein the diagnosing of whether the any o ne battery cell of the plurality of battery cells is abnormal by comparing the voltage devi ation of each of the plurality of battery cells with a threshold value comprises determinin g whether the maximum value among the positive deviations of each of the plurality of b attery cells exceeds an upper threshold value and whether the maximum value among th e negative deviations of each of the plurality of battery cells is less than a lower threshol d value.

12. The operating method of claim 11, wherein the diagnosing of whether the any o ne battery cell of the plurality of battery cells is abnormal by comparing the voltage devi ation of each of the plurality of battery cells with a threshold value comprises, when the maximum value among the positive deviations of the any one battery cell of the plurality of battery cells exceeds the upper threshold value and the maximum value among the ne gative deviations of the battery cell is less than the lower threshold value, diagnosing the battery cell as an abnormal battery cell.
